# EUROPÄISCHE PATENTSCHRIFT

(11) **EP 3 671 246 B1**
(45) Veröffentlichungstag und Bekanntmachung des Hinweises auf die Patenterteilung: **10.04.2024**
(21) Anmeldenummer: 19216375.6
(22) Anmeldetag: 16.12.2019
(51) Int. Cl.: G01R 33/00, G01R 31/28

(54) **VORRICHTUNG UND VERFAHREN ZUR PRÜFUNG UND KALIBRIERUNG EINES BAUTEILS**
DEVICE AND METHOD FOR TESTING AND CALIBRATING A COMPONENT
DISPOSITIF ET PROCÉDÉ D'ESSAI ET D'ÉTALONNAGE D'UN COMPOSANT

(30) Priorität: 19.12.2018 DE 102018132940
(43) Veröffentlichungstag der Anmeldung: 24.06.2020
(73) Patentinhaber: TDK-Micronas GmbH, 79108 Freiburg (DE)
(72) Erfinder: Kawaletz, Oliver, 79108 Freiburg (DE); Cornils, Martin, 79108 Freiburg (DE)
(74) Vertreter: Sonnenberg Harrison Partnerschaft mbB

(56) Entgegenhaltungen:
- CN-A- 106 871 948
- US-A1- 2013 008 628
- US-A1- 2013 038 321
- US-B1- 6 191 599

## Beschreibung

Die Erfindung betrifft eine Vorrichtung zur Prüfung und Kalibrierung eines Bauteils in einem magnetischen Feld sowie ein Verfahren zur Durchführung der Prüfung und Kalibrierung des Bauteils in dem magnetischen Feld.

Zur Charakterisierung und Kalibrierung von Bauteilen wie Magnetfeldsensoren müssen die Bauteile unter definierten Umgebungsparametern elektrisch vermessen werden. Diese Umgebungsparameter sind z.B. die Stärke und Orientierung des Magnetfelds sowie Temperatur und Feuchtigkeit. Dabei müssen einige Herausforderungen überwunden werden. Die Umgebungsparameter müssen unabhängig voneinander sehr präzise kontrolliert werden, um zuverlässige Messergebnisse zu erhalten. Es muss eine zuverlässige, elektrische Kontaktierung des Bauteils mit einem Messgerät im gesamten Umgebungsparameterraum sichergestellt werden. Parasitäre Störeinflüsse, die sich auf die Funktion der Bauteile (Magnetfeldsensoren) auswirken können, zum Beispiel mechanische Spannungen und/oder magnetische Störfelder, sollten eliminiert werden. Die Testumgebung muss robust sein und einen möglichen hohen Durchsatz für die Anwendung in einer Produktionshalle haben.

Vorrichtungen und Verfahren zur Prüfung und Kalibrierung des Bauteils sind an sich bekannt. Zum Beispiel zeigt die US Patentanmeldung Nr. US 2010/0308812 A1 (Infineon) ein Testsystem mit einem Träger für ein Halbleiter-Bauteil und einen Magnetfeldgenerator in der Nähe des Trägers. In dem beschriebenen Verfahren wird das Magnetfeld durch den Magnetfeldgenerator erzeugt und die Auswirkung des Magnetfelds auf das Bauteil erfasst. Ferner zeigt die US Patentanmeldung Nr. US 2013 / 0 038 321 A1 eine Magnetsensor-Inspektionsvorrichtung mit einem rechteckigen Rahmen, der eine Probenkarte und mehrere Magnetfelderzeugungsspulen enthält. Auf einem Tisch des Rahmens ist eine scheibenartige Anordnung von Magnetsensoren angebracht, die in horizontaler und vertikaler Richtung bewegbar ist. Die Probenkarte enthält eine Vielzahl von Sonden, die mit einer Vielzahl von Magnetsensoren in Kontakt gebracht werden, die in einem Messbereich enthalten sind. Die Magnetfelderzeugungsspulen werden angesteuert, um ein Magnetfeld in Richtung des Tisches zu erzeugen. Eine Vielzahl von Sensoren zur Messung der Magnetfeldumgebung ist in dem peripheren Abschnitt der Probenkarte angeordnet, der die Proben umgibt. Eine Magnetfeldsteuerung steuert Magnetfelder, die von den Magnetfelderzeugungsspulen erzeugt werden, basierend auf dem Messergebnis der Magnetfeldumgebungsmesssensoren. Somit ist es möglich, eine scheibenartige Anordnung von Magnetsensoren gleichzeitig mit der Probenkarte zu untersuchen. Ferner zeigt die CN 106 871 948 A eine Vorrichtung zur Prüfung eines Bauteils umfassend einen Probenhalter, einen Magnetfeldgenerator und eine Zuführung und Abführung für ein temperiertes Medium, wobei das Medium durch eine Röhre strömt. Des Weiteren zeigt die US 6 191 599 B1 eine Temperaturkontrollvorrichtung für eine zu testende integrierte Schaltung, die für das Erwärmen oder Abkühlen der Rückseite der integrierten Schaltung sorgt, während sie durch Kontakte und elektrische Leitungen getestet wird, die an die gegenüberliegende Zuleitungsseite derselben angelegt werden. Ein Testgehäuse definiert eine abgedichtete Testkammer, in der eine Testhalterung zum Befestigen der zu testenden integrierten Schaltung vorgesehen ist. Die Testhalterung ist mit einer Vielzahl von Testleitungen verbunden, um Testsignale zwischen der Zuleitungsseite der integrierten Schaltung und einem Testinstrument außerhalb der Testvorrichtung zu leiten. Die integrierte Schaltung ist an der Testhalterung angebracht, um ihre Rückseite einem Strom eines Wärmeübertragungsmediums in der abgedichteten Testkammer auszusetzen, um für deren Kühlung oder Erwärmung zu sorgen. Ein Beobachtungsfenster im Testgehäuse ermöglicht die Beobachtung der Rückseite des Geräts während des Tests. Des Weiteren zeigt die US 2013 / 0 008 628 A1 eine Thermokammer und System zur Beeinflussung der Temperatur eines zu testenden IC-Chips, umfassend einen Thermoblock, der einen Chipsockel aufnimmt, wobei der Thermoblock zwischen einer Andockschnittstellenplatte und einer Arbeitspresse angeordnet werden kann. Der Thermoblock empfängt einen Strom von erwärmtem oder abgekühltem Gas und bewirkt, dass ein IC-Chip vor und während eines Tests des Chips erwärmt oder abgekühlt wird. Die Wärmekammer und das System ermöglichen das Testen eines IC-Chips unter bestimmten Temperaturbedingungen

Andere Vorrichtungen und Verfahren sind den Erfindern bekannt. Diese zeigen Nachteile wie unpräzise Magnetfelder durch Verwendung von schlecht dimensionierten Spulen als Magnetfeldgeneratoren, Instabilität der erzeugten Magnetfelder durch Temperaturschwanken der Spulen in den Magnetfeldgeneratoren, unzuverlässige elektrische Kontaktierung der Bauteile, mechanische Spannung in den zu vermessenden Bauteilen, und lange Einschwingseiten für Magnetfelder und Temperatur.

Die Erfindung liegt daher der Aufgabe zu Grunde, eine verbesserte Vorrichtung und ein verbessertes Verfahren zur Prüfung und Kalibrierung eines Bauteils zu entwickeln.

In einem Aspekt der Erfindung umfasst die Vorrichtung einen Probenhalter mit einem Modul zur Aufnahme von mindestens einem Bauteil, mindestens einem Magnetfeldgenerator zur Erzeugung eines magnetischen Felds um den Probenhalter, und eine Zuführung zur Zuführung eines temperierten Mediums in das Modul sowie eine Abführung zur Abführung eines temperierten Mediums aus dem Modul. Bei dieser Vorrichtung befindet sich der Magnetfeldgenerator außerhalb des Bereichs, in dem die Umgebungsparameter geändert werden. Diese Trennung der Quellen der Umgebungsparameter untereinander sowie gegenüber dem Modul ermöglicht eine schnellere Änderung der Umgebungsparameter für das Bauteil, da der Magnetfeldgenerator auch nicht erwärmt werden muss, wie in dem Stand der Technik bekannt. Lediglich die Temperatur des kleineren Moduls mit dem Bauteil muss geändert werden. Die Umgebungstemperatur des Magnetfeldgenerators bleibt somit weitgehend konstant und daher ist das Magnetfeld auch stabil. Das relativ kleine Modul mit dem/den Bauteil(-en) kann auch schnell erwärmt und abgekühlt werden. Der Probenhalter hat mindestens eine Zuführöffnung zur Weiterführung des temperierten Mediums von der Zuführung in einen Hohlraum in dem Modul und mindestens eine Abführöffnung des temperierten Mediums aus dem Hohlraum des Moduls zu der Abführung. Die Zuführung und die Abführung sind derart angeordnet, dass der Probenhalter zwischen der Zuführung und der Abführung positionierbar ist. Das Bauteil oder die Bauteile sind somit zwischen der Zuführöffnung und der Abführöffnung in dem Hohlraum angeordnet, damit es/sie von dem temperierten Medium angeströmt wird/werden.

In einem Aspekt der Erfindung besteht der Probenhalter mit dem Modul aus zwei Teilen. Der Hohlraum ist durch gegenüberliegende Aussparungen in den zwei Teilen oder in einem der zwei Teile gebildet. Durch Zusammenbringung der zwei Teile wird das Bauelement in dem Hohlraum positioniert und kann zuverlässig festgehalten und elektrisch kontaktiert werden.

Der Magnetfeldgenerator umfasst eine Mehrzahl von Spulen, die orthogonal zueinander angeordnet sind. In einem Aspekt sind die Spulen als Helmholtz-Spulen aufgebaut und das erzeugte magnetische Feld ist somit weitgehend homogen entlang der Achse der Helmholtz-Spulen. Das Bauteil ist in einem weitgehend homogenen Bereich rund um die gemeinsamen Achsen der Spulen angeordnet.

Der Probenhalter weist mehrere Anschlusselemente in dem Hohlraum zum Kontaktieren des Bauteils auf. Diese Anschlusselemente sind vorzugsweise als Federkontaktstifte ausgebildet und kontaktieren das Bauteil bei Zusammenbringen der zwei Teile des Probenhalters.

Der Probenhalter kann auch Führungskanäle in dem Modul und Hohlraum aufweisen, welche das temperierte Medium um das Bauteil herumleiten.

Ein Steuerungs- und Messgerät zur Steuerung der Vorrichtung mit dem temperierten Medium und dem Magnetfeld sowie zur Evaluierung der Messdaten ist auch vorhanden.

Das Verfahren zur Prüfung und Kalibrierung des Bauteils umfasst die Einführung eines Probenhalters mit einem in einem Modul montierten Bauteil in ein magnetisches Feld. Danach wird eine Zuführung der Vorrichtung an eine Zuführöffnung in dem Probenhalter und eine Abführung der Vorrichtung an eine Abführöffnung in dem Probenhalter gebracht, derart, dass das Bauteil zwischen der Zuführöffnung und der Abführöffnung angeordnet ist, wobei der Probenhalter zwischen der Zuführung und der Abführung positionierbar ist. Anschließend wird das Modul mit einem temperierten Medium von der Zuführung zu der Abführung angeströmt. Wie oben aufgeführt wird das temperierte Medium nur durch das relativ kleine Modul durchgeführt. Somit können die Umgebungsparameter schneller geändert werden.

Die Erfindung wird nun anhand der Zeichnungen näher erläutert. Es zeigen:
Fig. 1 eine perspektivische Darstellung der Vorrichtung von einer ersten Seite;
Fig. 2 eine perspektivische Darstellung der Vorrichtung von der anderen Seite;
Fig. 3A eine Seitenansicht der Vorrichtung und Fig. 3B eine Schnittzeichnung der Vorrichtung von der gleichen Position;
Fig. 4 eine Zeichnung eines Probenhalters;
Fig. 5A und 5B eine Schnittzeichnung des Endes des Probenhalters;
Fig. 6 das untere Teil des Probenhalters;
Fig. 7 eine Schnittzeichnung des Probenhalters mit elektrischen Anschlusselementen;
Fig. 8 einen Ablauf des Verfahrens.

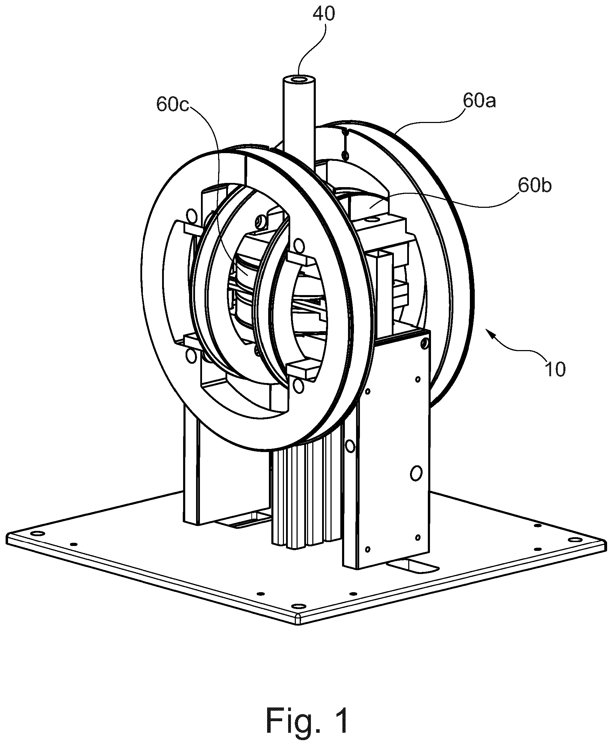

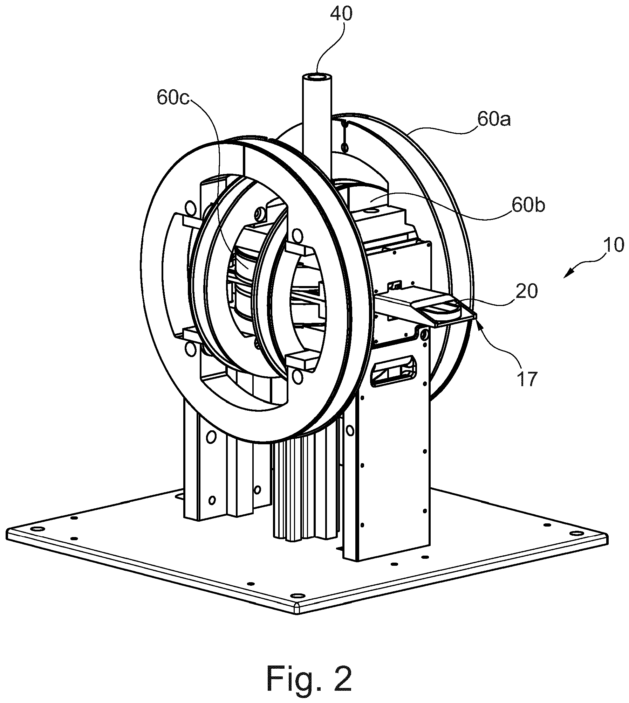

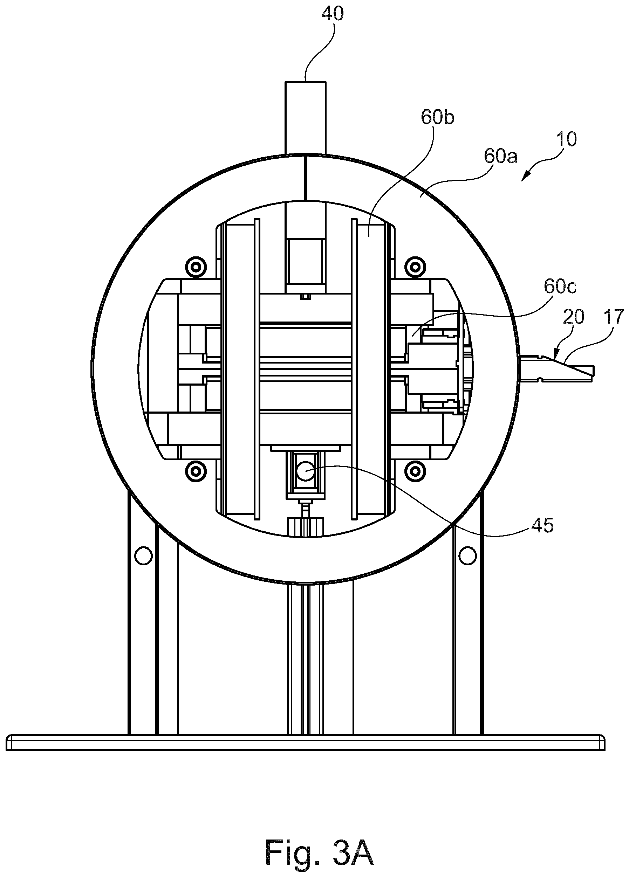

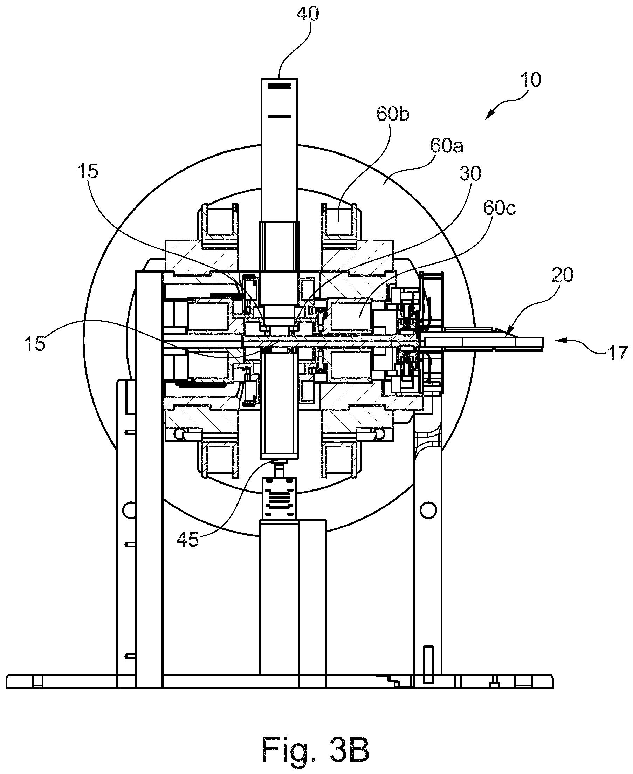

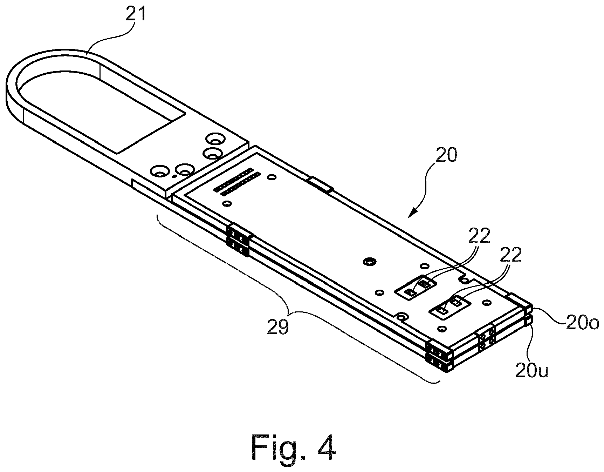

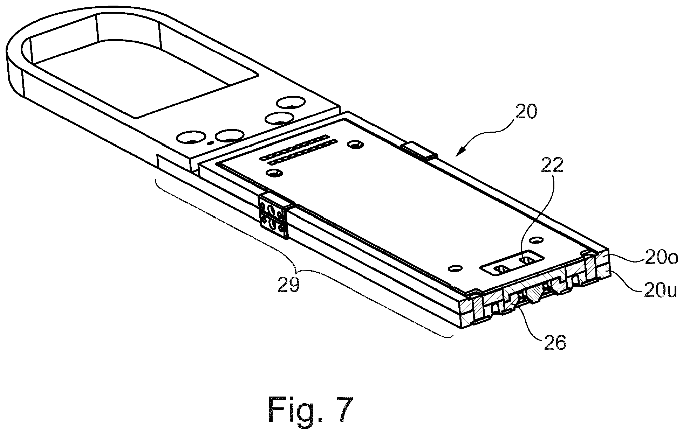

Fig. 1 und 2 zeigen zwei perspektivische Darstellungen einer Vorrichtung 10 zur Prüfung und Kalibrierung mindestens eines Bauteils 30, das in einem Probenhalter 20 aufgenommen ist. Die Figuren 3A und 3B zeigen eine Seitenansicht der gleichen Vorrichtung 10, wobei die Fig. 3A das externe Aussehen der Vorrichtung 10 und Fig. 3B eine Schnittdarstellung mit dem Innenleben der Vorrichtung 10 zeigt. In den Figuren 1 und 2 ist das Bauteil 30 nicht erkennbar, da das Bauteil 30 sich innerhalb der Vorrichtung 10 befindet. Der Probenhalter 20 ist in den Figuren 4, 5A, 5B, 6 und 7 detaillierter dargestellt und wird später näher beschrieben. Figs. 2 und 3B zeigen den Probenhalter 20 montiert in der Vorrichtung 10.

Die Vorrichtung 10 weist einen Magnetfeldgenerator auf, der in Fig. 1 und 2 aus insgesamt zehn paarweise angeordneten Spulen besteht. In den Zeichnungen sind nur drei Spulenpaare 60a, 60b und 60c zu erkennen. Zwei weitere Spulenpaare sind innerhalb des Magnetfeldgenerators in der gleichen Ausrichtung wie das Spulenpaar 60c angeordnet. Jedes Spulenpaar ist vorzugsweise in einer Art "Helmholtz"-Anordnung mit einem weitgehend homogenen magnetischen Feld in der Nähe seiner Spulenachse ausgebildet. Die Spulenpaare 60a, 60b und 60c sind jeweils orthogonal zueinander angeordnet und ihre Achsen weisen einen gemeinsamen Schnittpunkt 15 (dargestellt in der Schnittansicht Fig. 3B) auf. Das Bauteil 30 ist in der Vorrichtung 10 so angebracht, dass es sich weitgehend an dem oder um den Schnittpunkt 15 an der Kreuzung der Spulenachsen der Spulenpaare 60a, 60b und 60c befindet. An diesem Schnittpunkt15 ist daher das durch die Spulenpaare 60a, 60b und 60c erzeugte magnetische Feld in allen Richtungen weitgehend homogen.

Die Vorrichtung 10 verfügt über eine Zuführung 40 und eine Abführung 45, welche jeweils ein temperiertes Medium in die Vorrichtung 10 hineinleiten und aus der Vorrichtung 10 herausleiten. Das temperierte Medium ist zum Beispiel Luft bei einer vorbestimmten Temperatur und Feuchtigkeit. Aus Fig. 3B ist zu erkennen, dass die Zuführung 40 das temperierte Medium an das Bauteil 30 zuführt und die Abführung 45 das temperierte Medium ableitet. Die Abführung 45 ist mit einer nicht dargestellten Entsorgungsvorrichtung verbunden. Das temperierte Medium könnte auch ein anderes Gas z.B. ein Edelgas sein.

Der Probenhalter 20 kann in die Vorrichtung 10 durch eine Halteröffnung 17 ein- und ausgeführt werden. Diese Ein- und Ausführung kann automatisch oder manuell erfolgen. In einem weiteren Aspekt ist der Probenhalter 20 Teil eines Leadframes (Anschlussrahmens) mit einer Mehrzahl von Bauteilen 30, der durch die Halteröffnung 17 in der Vorrichtung 10 in einem kontinuierlichen oder semi-kontinuierlichen Verfahren durchgezogen wird. Der Leadframe kann zum Beispiel Bauteile in Abschnitten von 8 x 20 Bauteilen aufweisen, wobei diese Größe nicht limitierend für die Erfindung ist.

Der Probenhalter 20 ist in Figuren 4, 5A, 5B, 6 und 7 dargestellt und umfasst einen Griff 21 zur Erfassung des Probenhalters 20 bei der Ein- und Ausführung des Probenhalters 20 in die Vorrichtung 10, einen Körper 29 und am anderen Ende des Körpers 29 ein Modul 28, in dem sich das Bauteil 30 in einem Hohlraum 25 befindet.

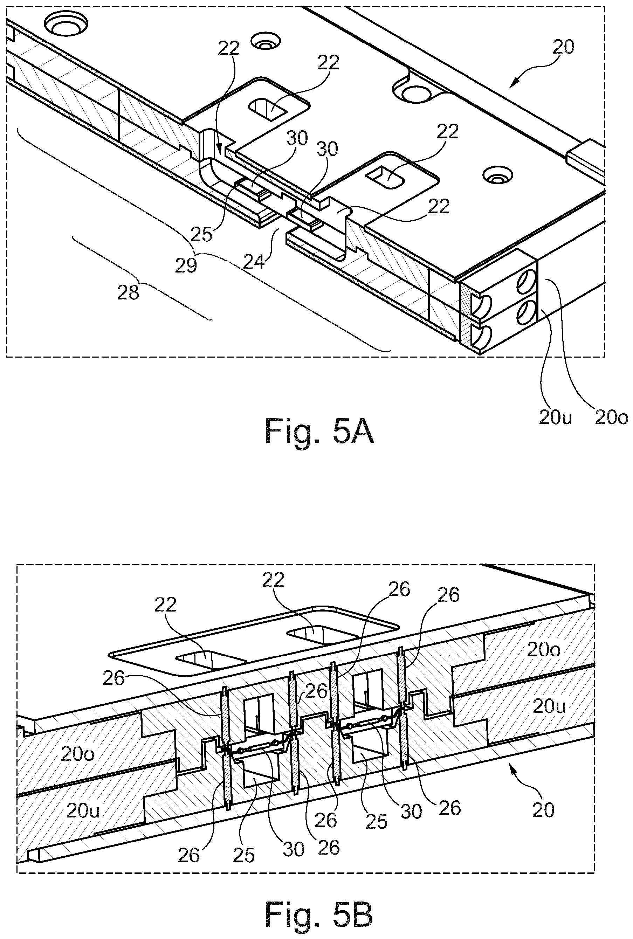

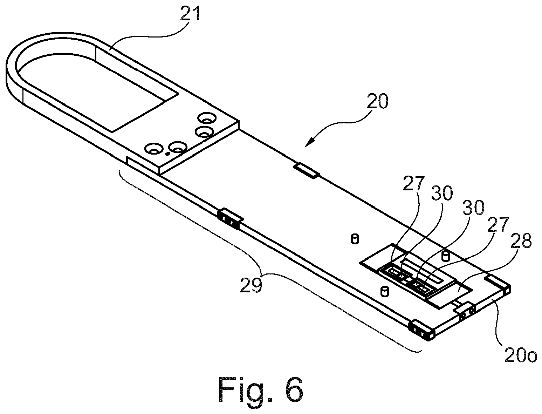

Fig. 4 zeigt den Probenhalter 20 mit einem oberen Teil 20o und einem unteren Teil 20u, die zusammengesetzt sind. Fig. 5A und 5B zeigen zwei Darstellungen einer Schnittzeichnung des unteren Endes des Probenhalters 20 mit dem Hohlraum 25 und lässt somit das Modul 28 mit dem Hohlraum 25 besser erkennen. Fig. 6 zeigt das untere Teil 20u des Probenhalters 20 mit dem Modul 28 für das Bauteil 30.

Mindestens eine Zuführöffnung 22 ist in der oberen Fläche des Körpers 29 eingebracht. In den Figuren 4 und 5A sind vier Zuführöffnungen 22 und in Fig. 5B sind zwei Zuführöffnungen 22 dargestellt, wobei die Anzahl der Zuführöffnungen 22 nicht einschränkend für die Erfindung ist. Diese Zuführöffnungen 22 sind in der Vorrichtung 10 bei der Position 15 so angeordnet, dass die Zuführöffnungen 22 mit der Zuführung 40 verbunden sind und somit die Anströmung des temperierten Mediums in das Modul 28 und durch den Hohlraum 25 mit dem Bauteil 30 ermöglicht.

In der unteren Fläche ist in Fig. 5A zu sehen, dass eine Abführöffnung 24 vorhanden ist, welche die Abführung des temperierten Mediums aus dem Modul 28 und Hohlraum 25 ermöglicht. Diese Abführöffnung 24 ist mit der Abführung 45 (Fig. 3A und 3B) in der Vorrichtung 10 bei der Position 15 verbunden. Die Zuführung des temperierten Mediums von der Zuführung 40 durch die Zuführöffnung 22 in das Modul 28 und die Abführung des temperierten Mediums durch die Abführöffnung 24 aus dem Modul 28 an die Abführung 45 ermöglichen somit ein Anströmen des Bauteils 30 in dem Modul 28 mit dem temperierten Medium.

Innerhalb des Moduls 28 können auch Führungskanäle so angebracht werden, dass das Bauteil 30 durch das temperierte Medium mit definierten Stromrichtungen angeströmt wird. Dadurch wird eine gute und schelle thermische Anbindung des Bauteils 30 erreicht.

Das Modul 28 mit dem Hohlraum 25 ist individuell und passgenau für die Bauteile 30 ausgerichtet. Dies stellt sicher, dass keine mechanischen Spannungen in dem Bauteil 30 erzeugt werden.

Aus Figs. 5A, 5B und 6 ist zu erkennen, dass der Körper 29 des Probenhalters 20 aus zwei Bestandteilen 20u und 20o besteht, die aneinander gebracht werden, um das Bauteil 30 in dem Hohlraum 25 zu halten. Natürlich sind andere Verfahren zum Festhalten des Bauteils 30 möglich. Die zwei Bestandteile 20o und 20u weisen jeweils eine Aussparung auf, welche gemeinsam den Hohlraum 25 bilden. Es ist auch möglich, dass nur eines der Bestandteile 20u, 20o die Aussparung für den Hohlraum 25 aufweist.

Figs. 4, 5A, 5B und 6 zeigen das Modul 28 und den Hohlraum 25 mit Platz für jeweils zwei Bauteile 30. Der Probenhalter 20 kann so gebaut werden, dass der Probenhalter 20 mehrere Bauteile 30 aufnehmen könnte und die Anzahl der Bauteile ist somit nicht einschränkend für die Erfindung

Fig. 5B zeigt den Probenhalter 20 mit mehreren Anschlusselementen 26, die in einem Aspekt als Federkontaktstifte aufgebaut sind und den elektrischen Kontakt mit dem Bauteil 30 ermöglichen. Die Anschlusselemente 26 leiten Signale und Leistung zwischen dem Bauteil 30 und einem nicht dargestellten Steuerungs- und Messgerät über (nicht dargestellten) Leiterbahnen in dem Probenhalter 30. Dadurch kann das Bauteil 30 geprüft werden. Das Steuerungsgerät kann die Stärke des Magnetfelds in der Vorrichtung 10 variieren und auch die Eigenschaften (Temperatur, Feuchtigkeit) des temperierten Mediums und dabei die Umgebungsparameter des Bauteils 30 ändern. Somit lassen sich eine Vielzahl von Tests in unterschiedlichen Umgebungen durchführen.

In dem weiteren Aspekt mit einem Leadframe werden die Bauteile 20 über z.B. eine Nadelkarte oder über Federkontaktstifte (Pogo-Pins) kontaktiert.

Die ganze Vorrichtung 10 ist in einem Rahmen untergebracht, welcher bewegliche Teile z.B. Pneumatik-Zylinder aufweist, um den Probenhalter 20 in die Vorrichtung ein- und auszuschieben sowie um die zwei Teile des Probenhalters 20 zusammen zu halten.

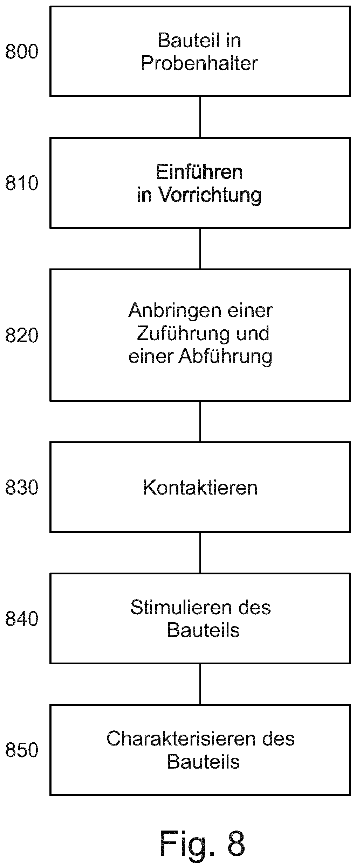

Der Ablauf des Verfahrens zur Prüfung und Kalibrierung des Bauteils 30 ist in Fig. 8 kurz erläutert. In einem ersten Schritt 800 wird das Bauteil 30 in den Probenhalter 20 eingebracht und gehalten. Es ist dabei zu beachten, dass das Festhalten des Bauteils 30 in dem Probenhalter 20 keine mechanischen Spannungen in dem Bauteil 30 auslöst.

Der Probenhalter 20 mit dem Bauteil 30 wird in die Vorrichtung 10 eingeführt im Schritt 810 und im Schritt 820 wird der Probenhalter 20 so positioniert an der Position 15, dass die Zuführöffnungen 22 des Probenhalters 20 mit der Zuführung 40 der Vorrichtung verbunden sind. Ebenfalls ist die Abführöffnung 24 des Probenhalters 20 mit der Abführung 45 der Vorrichtung verbunden. Das Bauteil 30 wird im Schritt 830 elektrisch kontaktiert und im Schritt 840 wird das Bauteil 30 stimuliert (magnetisch / thermisch / elektrisch), damit das Bauteil 30 im Schritt 850 charakterisiert wird. Dabei können die unterschiedlichen Umgebungsparameter (Temperatur, Feuchte, Feldstärke) in dem Schritt geändert werden.

### Bezugszeichen

- 10: Vorrichtung
- 15: gemeinsamer Schnittpunkt der Spulenachsen
- 17: Halteröffnung
- 20: Probenhalter
- 20o: Oberes Teil
- 20u: Unteres Teil
- 21: Griff
- 22: Zuführöffnung
- 24: Abführöffnung
- 25: Hohlraum
- 26: Anschlusselemente
- 28: Modul
- 29: Körper
- 30: Bauteil
- 40: Zuführung
- 45: Abführung
- 60a, 60b, 60c: Spulenpaare

## Patentansprüche

1. Vorrichtung (10) zur Prüfung und/oder Kalibrierung eines Bauteils (30) umfassend:
einen Probenhalter (20) mit einem Modul (28) zur Aufnahme von mindestens einem Bauteil (30);
mindestens einen Magnetfeldgenerator (60a, 60b, 60c) zur Erzeugung eines magnetischen Felds um das Modul (28);
eine Zuführung (40) zur Zuführung eines temperierten Mediums in das Modul (28); und
eine Abführung (45) zur Abführung eines temperierten Mediums aus dem Modul (28), wobei der Probenhalter (20) mindestens eine Zuführöffnung (22) zur Weiterführung des temperierten Mediums von der Zuführung (40) in das Modul (28) und mindestens eine Abführöffnung (24) des temperierten Mediums aus dem Modul (28) zu der Abführung (45) aufweist, wobei das mindesten eine Bauteil (30) zwischen der Zuführöffnung (22) und der Abführöffnung (24) angeordnet ist, und wobei die Zuführung (40) und die Abführung (45) derart angeordnet sind, dass der Probenhalter (20) zwischen der Zuführung (40) und der Abführung (45) positionierbar ist.

2. Vorrichtung (10) nach Anspruch 1, wobei der Probenhalter (20) aus zwei Teilen (20o, 20u) besteht und ein Hohlraum (25) in dem Modul (28) entweder durch gegenüberliegende Aussparungen in den zwei Teilen (20o, 20u) gebildet ist oder in einem der zwei Teile (20o, 20u) geformt ist.

3. Vorrichtung (10) nach Anspruch 2, weiter umfassend ein bewegliches Element zum Zusammenpressen der zwei Teile des Probenhalters (20).

4. Vorrichtung (10) nach einem der vorhergehenden Ansprüche, wobei der Magnetfeldgenerator (60a, 60b, 60c) eine Mehrzahl von Spulen umfasst.

5. Vorrichtung (10) nach Anspruch 4, wobei die Spulen (60a, 60b, 60c) orthogonal zueinander angeordnet sind.

6. Vorrichtung (10) nach einem der vorhergehenden Ansprüche, wobei der Magnetfeldgenerator (60a, 60b, 60c) als ein Helmholtz-Spulensystem gebaut ist und das erzeugte magnetische Feld weitgehend homogen ist.

7. Vorrichtung (10) nach einem der Ansprüche 4 bis 6, wobei der Magnetfeldgenerator (60a, 60b, 60c) eine Vielzahl von Paaren von Spulen (60a, 60b, 60c) um das Modul (28) umfasst.

8. Vorrichtung (10) nach einem der Ansprüche 4 bis 7, wobei das mindestens eine Bauteil (30) auf/um den gemeinsamen Schnittpunkt (15) der Achsen der Spulen (60a, 60b, 60c) angeordnet ist.

9. Vorrichtung nach einem der Ansprüche 1 bis 8, wobei der Probenhalter (20) mehrere Anschlusselemente (26) zum Kontaktieren des Bauteils (30) aufweist.

10. Vorrichtung nach Anspruch 9, weiter umfassend mehrere bewegbare Kontaktstifte zum Kontaktieren des Probenhalters (20).

11. Vorrichtung nach einem der vorhergehenden Ansprüche, wobei der Probenhalter (20) Führungskanäle (27) aufweist, welche das temperierte Medium um das Bauteil (30) leiten.

12. Vorrichtung (10) nach einem der vorhergehenden Ansprüche, wobei das mindestens eine Bauteil (30) Kontaktdrähte aufweist, die von dem temperierten Medium umströmt werden.

13. Vorrichtung (10) nach einem der vorhergehenden Ansprüche, weiter umfassend ein Steuerungsgerät zur Temperatursteuerung des temperierten Mediums.

14. Verfahren zur Prüfung und Kalibrierung eines Bauteils (30) in einer Vorrichtung (10) umfassend:
Einführen (810) eines Probenhalters (20) mit einem in einem Hohlraum (25) montierten Bauteil (30) in ein magnetisches Feld;
Anbringen (820) einer Zuführung(40) der Vorrichtung (10) an eine Zuführöffnung (22) in dem Probenhalter (20);
Anbringen (820) einer Abführung (45) der Vorrichtung (10) an eine Abführöffnung (24) in dem Probenhalter (20), derart, dass das Bauteil (30) zwischen der Zuführöffnung (22) und der Abführöffnung (24) angeordnet ist, wobei der Probenhalter (20) zwischen der Zuführung (40) und der Abführung (45) positionierbar ist;
Stimulieren (840) der Bauteile (30) im Hohlraum (25).

15. Verfahren nach Anspruch 14 umfassend
Ändern der Umgebungsparameter.

16. Verfahren nach Anspruch 14 oder 15, weiter umfassend
Kontaktieren (830) des Bauteils und Durchführen einer Charakterisierung (850)

17. Verfahren nach einem der Ansprüche 14 bis 16, weiter umfassend das Durchführen des Probenhalters (20) durch die Vorrichtung (10) in einem kontinuierlichen Verfahren.

18. Probenhalter (20) umfassend
einen oberen Teil (20o) beinhaltend eine Zuführöffnung (22); und einen unteren Teil (20u) beinhaltend eine Abführöffnung (24); wobei das obere Teil (20o) eine Aussparung und das untere Teil (20u) eine Aussparung aufweisen und bei Zusammenfügung des oberen Teils (20o) mit dem unteren Teil (20u) durch diese Aussparungen ein Hohlraum (25) zur Aufnahme eines Bauteils (30) gebildet wird, und
wobei das Bauteil (30) in dem Hohlraum (25) derart angeordnet ist, dass ein temperiertes Medium durch den Hohlraum (25) um das Bauteil (30) strömen kann.

19. Probenhalter (20) nach Anspruch 18, wobei der Probenhalter (20) Führungskanäle (27) zur Lenkung des temperierten Mediums um das Bauteil (30) aufweist.

20. Probenhalter (20) nach Ansprüche 18 oder 19, weiter umfassend Anschlusselemente (26) zum elektrischen Kontaktieren des Bauteils (30).

## Claims

1. A device (10) for checking and/or calibrating a component (30), comprising:
a sample holder (20) having a module (28) for receiving at least one component (30);
at least one magnetic field generator (60a, 60b, 60c) for generating a magnetic field around the module (28);
an inlet (40) for feeding a tempered medium into the module (28); and
an outlet (45) for discharging a tempered medium from the module (28), wherein the sample holder (20) has at least one inlet opening (22) for guiding the tempered medium from the inlet (40) into the module (28) and at least one outlet opening (24) for discharging the tempered medium from the module (28) to the outlet (45), wherein the at least one component (30) is arranged between the inlet opening (22) and the outlet opening (24), and wherein the
inlet (40) and the outlet (45) are arranged such that the sample holder (20) can be positioned between the inlet (40) and the outlet (45).

2. The device (10) according to claim 1, wherein the sample holder (20) consists of two parts (20o, 20u) and a cavity (25) in the module (28) is either formed by mutually opposite recesses in the two parts (20o, 20u) or is formed in one of the two parts (20o, 20u).

3. The device (10) according to claim 2, further comprising a movable element for pressing the two parts of the sample holder (20) together.

4. The device (10) according to any one of the preceding claims, wherein the magnetic field generator (60a, 60b, 60c) comprises a plurality of coils.

5. The device (10) according to claim 4, wherein the coils (60a, 60b, 60c) are arranged orthogonally to each other.

6. The device (10) according to any one of the preceding claims, wherein the magnetic field generator (60a, 60b, 60c) is designed as a Helmholtz coil system and the generated magnetic field is substantially homogeneous.

7. The device (10) according to any one of claims 4 to 6, wherein the magnetic field generator (60a, 60b, 60c) comprises a plurality of pairs of coils (60a, 60b, 60c) around the module (28).

8. The device (10) according to any one of claims 4 to 7, wherein the at least one component (30) is arranged on/around the common intersection (15) of the axes of the coils (60a, 60b, 60c).

9. The device according to any one of claims 1 to 8, wherein the sample holder (20) comprises a plurality of connection elements (26) for contacting the component (30).

10. The device according to claim 9, further comprising a plurality of movable contact pins for contacting the sample holder (20).

11. The device according to any one of the preceding claims, wherein the sample holder (20) comprises guide channels (27) which guide the tempered medium around the component (30).

12. The device (10) according to any one of the preceding claims, wherein the at least one component (30) comprises contact wires around which the tempered medium flows.

13. The device (10) according to any one of the preceding claims, further comprising a control apparatus for controlling the temperature of the tempered medium.

14. A method for checking and calibrating a component (30) in a device (10), comprising:
introducing (810) a sample holder (20) with a component (30) mounted in a cavity (25) into a magnetic field;
attaching (820) an inlet (40) of the device (10) to an inlet opening (22) in the sample holder (20);
attaching (820) an outlet (45) of the device (10) to an outlet opening (24) in the sample holder (20) such that the component (30) is arranged between the inlet opening (22) and the outlet opening (24), wherein the sample holder (20) can be positioned between the inlet (40) and the outlet (45);
stimulating (840) the components (30) in the cavity (25).

15. The method according to claim 14, comprising
changing the environmental parameters.

16. The method according to claim 14 or 15, further comprising contacting (830) the component and performing a characterization (850)

17. The method according to any one of claims 14 to 16, further comprising guiding the sample holder (20) through the device (10) in a continuous process.

18. A sample holder (20), comprising
an upper part (20o) including an inlet opening (22); and
a lower part (20u) including an outlet opening (24);
wherein the upper part (20o) comprises a recess and the lower part (20u) comprises a recess, and a cavity (25) for receiving a component (30) is formed by these recesses when the upper part (20o) is joined to the lower part (20u), and
wherein the component (30) is arranged in the cavity (25) such that a tempered medium can flow through the cavity (25) around the component (30).

19. The sample holder (20) according to claim 18, wherein the sample holder (20) comprises guide channels (27) for guiding the tempered medium around the component (30).

20. The sample holder (20) according to claim 18 or 19, further comprising connection elements (26) for electrically contacting the component (30).

## Revendications

1. Dispositif (10) pour tester et/ou calibrer un composant (30) comprenant :
un support d'échantillon (20) avec un module (28) pour accueillir au moins un composant (30);
au moins un générateur de champ magnétique (60a, 60b, 60c) pour créer un champ magnétique autour du module (28);
une alimentation (40) pour alimenter un milieu tempéré dans le module (28); et
une évacuation (45) pour évacuer un milieu tempéré du module (28),
dans lequel ledit support d'échantillon (20) comprend au moins une ouverture d'alimentation (22) pour guider le milieu tempéré de l'alimentation (40) dans le module (28) et au moins une ouverture d'évacuation (24) du milieu tempéré du module (28) vers l'évacuation (45), ledit au moins un composant (30) étant disposé entre l'ouverture d'alimentation (22) et l'ouverture d'évacuation (24), et dans lequel l'alimentation (40) et l'évacuation (45) sont disposées de sorte que le support d'échantillon (20) soit positionnable entre l'alimentation (40) et l'évacuation (45);

2. Dispositif (10) selon la revendication 1, dans lequel le support d'échantillon (20) est composé de deux parties (20o, 20u) et une cavité (25) dans le module (28) est soit formée par des évidements opposés dans les deux parties (20o, 20u) soit façonnée dans l'une des deux parties (20o, 20u).

3. Dispositif (10) selon la revendication 2, comprenant en outre un élément mobile pour comprimer ensemble les deux parties du support d'échantillon (20).

4. Dispositif (10) selon l'une quelconque des revendications précédentes, dans lequel le générateur de champ magnétique (60a, 60b, 60c) comprend une pluralité de bobines.

5. Dispositif (10) selon la revendication 4, dans lequel les bobines (60a, 60b, 60c) sont disposées orthogonalement les unes par rapport aux autres.

6. Dispositif (10) selon l'une quelconque des revendications précédentes, dans lequel le générateur de champ magnétique (60a, 60b, 60c) est construit comme un système de bobines de Helmholtz et le champ magnétique produit est essentiellement homogène.

7. Dispositif (10) selon l'une quelconque des revendications 4 à 6, dans lequel le générateur de champ magnétique (60a, 60b, 60c) comprend une pluralité de paires de bobines (60a, 60b, 60c) autour du module (28).

8. Dispositif (10) selon l'une quelconque des revendications 4 à 7, dans lequel ledit au moins un composant (30) est disposé sur/autour du point d'intersection commun (15) des axes des bobines (60a, 60b, 60c).

9. Dispositif selon l'une quelconque des revendications 1 à 8, dans lequel le support d'échantillon (20) comprend plusieurs éléments de raccordement (26) pour contacter le composant (30).

10. Dispositif selon la revendication 9, comprenant en outre plusieurs broches de contact mobiles pour contacter le support d'échantillon (20).

11. Dispositif selon l'une quelconque des revendications précédentes, dans lequel le support d'échantillon (20) comprend des canaux de guidage (27) qui dirigent le milieu tempéré autour du composant (30).

12. Dispositif (10) selon l'une quelconque des revendications précédentes, dans lequel le au moins un composant (30) comprend des fils de contact qui sont entourés par le milieu tempéré.

13. Dispositif (10) selon l'une quelconque des revendications précédentes, comprenant en outre un dispositif de commande pour commander la température du milieu tempéré.

14. Procédé de test et de calibration d'un composant (30) dans un dispositif (10) comprenant :
introduire (810) un support d'échantillon (20) avec un composant (30) monté dans une cavité (25) dans un champ magnétique;
fixer (820) une alimentation (40) du dispositif (10) à une ouverture d'alimentation (22) dans le support d'échantillon (20);
fixer (820) une évacuation (45) du dispositif (10) à une ouverture d'évacuation (24) dans le support d'échantillon (20), de sorte que le composant (30) soit disposé entre l'ouverture d'alimentation (22) et l'ouverture d'évacuation (24), ledit support d'échantillon (20) étant positionnable entre l'alimentation (40) et l'évacuation (45);
stimuler (840) des composants (30) dans la cavité (25).

15. Procédé selon la revendication 14 comprenant
modifier les paramètres environnementaux.

16. Procédé selon la revendication 14 ou 15, comprenant en outre
contacter (830) le composant et réaliser une caractérisation (850).

17. Procédé selon l'une quelconque des revendications 14 à 16, comprenant en outre passer le support d'échantillon (20) au travers du dispositif (10) selon un procédé continu.

18. Support d'échantillon (20) comprenant
une partie supérieure (20o) comprenant une ouverture d'alimentation (22); et
une partie inférieure (20u) comprenant une ouverture d'évacuation (24);
la partie supérieure (20o) ayant un évidement et la partie inférieure (20u) ayant un évidement, et lors de l'assemblage de la partie supérieure (20o) avec la partie inférieure (20u), une cavité (25) est formée par ces évidements pour accueillir un composant (30), et
le composant (30) étant disposé dans la cavité (25) de sorte qu'un milieu tempéré peut s'écouler au travers de la cavité (25) autour du composant (30).

19. Support d'échantillon (20) selon la revendication 18, dans lequel le support d'échantillon (20) comporte des canaux de guidage (27) pour diriger le milieu tempéré autour du composant (30).

20. Support d'échantillon (20) selon la revendication 18 ou 19, comprenant en outre des éléments de raccordement (26) pour contacter électriquement le composant (30).
